# EUROPÄISCHE PATENTANMELDUNG

(11) **EP 1 076 407 A2**
(43) Veröffentlichungstag der Anmeldung: **14.02.2001**
(21) Anmeldenummer: 00117426.7
(22) Anmeldetag: 11.08.2000
(51) Int. Cl.: H02N 6/00

(54) **Vorrichtung zur Umwandlung von solarenergie in elektrische Energie und zum Abstrahlen und/oder Empfangen von hochfrequenten, elektromagnetischen Wellen**

(30) Priorität: 12.08.1999 DE 19938199
(71) Anmelder: Institut für Solaire Energieversorgungstechnik (ISET) Verein an der Universität Gesampthochschule Kassel e.V., 34119 Kassel (DE)
(72) Erfinder: Bendel, Christian, Dr., 34270 Martinhagen (DE); Henze, Norbert, 34130 Kassel (DE); Kirchhof, Jörg, 34317 Habichtswald (DE)
(74) Vertreter: Freiherr von Schorlemer, Reinfried, Dipl.-Phys.

(57) **Zusammenfassung**

Es wird eine Vorrichtung (1) zur Umwandlung von Solarenergie in elektrische Energie und zum Abstrahlen und/oder Empfangen von hochfrequenten elektromagnetischen Wellen beschrieben. Die Vorrichtung (1) enthält wenigstens eine mit elektrisch leitenden Kontakten versehene Solarzelle (2), wobei wenigstens eine der Kontakte der Solarzelle gleichzeitig ein Antennenelement bildet (Fig. 1).

## Beschreibung

Die Erfindung betrifft eine Vorrichtung der im Oberbegriff des Anspruchs 1 angegebenen Gattung.

Bekannte Vorrichtungen dieser Art bestehen aus einer zusammenhängenden Baueinheit, die wenigstens eine Solarzelle, ein Antennenelement und ein elektronisches Bauelement in Form eines Display, eines Bild- oder Schallwandlers, einer Signalbearbeitungsschaltung od. dgl. enthält. Dabei besteht die Antenne in einer Variante aus einer mit dem Bauelement verbundenen Metallplatte, während mehrere Solarzellen nach Art eines das Bauelement umgebenden Rahmens angeordnet sind (JP-A 102 42 443). In einer anderen Variante ist die Antenne eine das Bauelement und die Solarzellenanordnung umgebende Rahmenantenne, die z.B. durch einen auf die Oberfläche des Bauelements aufgebrachten Leiter gebildet sein kann (WO 97/44 707). Derartige Vorrichtungen werden z.B. in tragbaren Radios, Fernsehern, Taschenrechnern oder ähnlichen Geräten angewendet.

Daneben ist es insbesondere in der Satellitentechnik bekannt, großflächige Antennen mit Hilfe von separat zu diesen angeordneten Solarzellenmodulen zu betreiben (US-PS 5 642 122, JP-A-08 274 527). Die Solarzellenmodule und Antennen werden hier zwar häufig körperlich miteinander verbunden, im übrigen aber wie üblich als räumlich und funktionell voneinander getrennte Bauteile verwendet. Das gilt auch in Fällen, in denen die Antennen als Parabolantennen ausgebildet sind und einen aus einem Metallgitter bestehenden Reflektor aufweisen, hinter dem ein Solarzellenmodul angeordnet ist (JP-A-91 35 110), oder in denen zur Bildung einer Planarantenne zwischen mit Abstand angeordneten Antennenelementen jeweils einzelne Solarzellen montiert werden (JP-A-60 27 734). Bei Vorrichtungen schließlich, die eine Mehrzahl von Antennenelementen, eine Mehrzahl von unter diesen angeordneten Solarzellen und eine zwischen diesen beiden angeordnete, leitfähige Beschichtung aufweisen, ist außerdem die Funktion der Solarzellen eingeschränkt, da diese teilweise von den Antennenelementen abgedeckt sind (JP-A-10 270 925).

Die beschriebenen Vorrichtungen nehmen trotz der Kombination von Solarzellen und Antennenelementen zu zusammenhängenden Baueinheiten noch vergleichsweise viel Raum in Anspruch, der sich aus der Summe des Raumbedarfs für die einzelnen Komponenten ergibt. Abgesehen davon sind die Solarzellen zumindest teilweise durch Antennenelemente abgedeckt, was ihre Funktion z.B. dann beeinträchtigt, wenn sie innerhalb von leistungsfähigen Fotovoltaikanlagen der kostengünstigen Erzeugung von Strom dienen sollen.

Der Erfindung liegt daher die Aufgabe zugrunde, die Vorrichtung der eingangs bezeichnenden Gattung so auszubilden, daß sie sich insbesondere zur Anwendung in Fotovoltaikanlagen eignet, konstruktiv einfach hergestellt werden kann und platzsparend ausgebildet ist.

Zur Lösung dieser Aufgabe dienen die kennzeichnenden Merkmale des Anspruchs 1.

Die erfindungsgemäße Vorrichtung bringt den Vorteil mit sich, daß Solarzellen und Antennen nicht nur zu einem integrierten Bauelement zusammengefaßt sind, sondern daß elektrisch leitende Kontakte, die in einer Solarzelle bzw. Solarzellenanordnung ohnehin betriebsbedingt vorhanden sind, gleichzeitig als Antennenelemente genutzt werden. Dadurch kann die zusätzliche Anbringung von Antennenelementen gänzlich vermieden werden.

Weitere vorteilhafte Merkmale der Erfindung ergeben sich aus den Unteransprüchen.

Die Erfindung wird nachfolgend in Verbindung mit den beiliegenden Zeichnungen an Ausführungsbeispielen näher erläutert. Es zeigen:
Fig. 1 schematisch eine erfindungsgemäße, mit einer Mehrzahl von Solarzellen versehenen Vorrichtung zur Umwandlung von Solarenergie in elektrische Energie und zum Empfangen von hochfrequenten, elektromagnetischen Wellen;
Fig. 2 schematisch eine zweite Ausführungsform der Vorrichtung nach Fig. 1, jedoch zum Senden von hochfrequenten, elektromagnetischen Wellen;
Fig. 3 eine schematische, perspektivische Darstellung zur An- bzw. Auskoppelung der HF-Wellen bei Anwendung einer einzigen Solarzelle;
Fig. 4 einen Querschnitt durch die Vorrichtung der Fig. 3;
Fig. 5 bis 9 der Fig. 3 entsprechende und teilweise auseinandergezogen dargestellte Ansichten von alternativen An- bzw. Auskopplungsarten;
Fig. 10 eine perspektivische und auseinandergezogen dargestellte Vorrichtung nach Fig. 1 mit vier, paarweise in Reihe geschalteten Solarzellen;
Fig. 11 und 12 Querschnitte durch zwei alternative Ausführungsformen der Vorrichtung nach Fig. 10;
Fig. 13 und 14 zwei Anwendungsbeispiele für die Vorrichtung nach Fig. 1;
Fig. 15 schematisch die Richtwirkung der Vorrichtung nach Fig. 14;
Fig. 16 einige Wellenzüge von HF-Wellen zur Erläuterung der Richtwirkung der Vorrichtung nach Fig. 14.

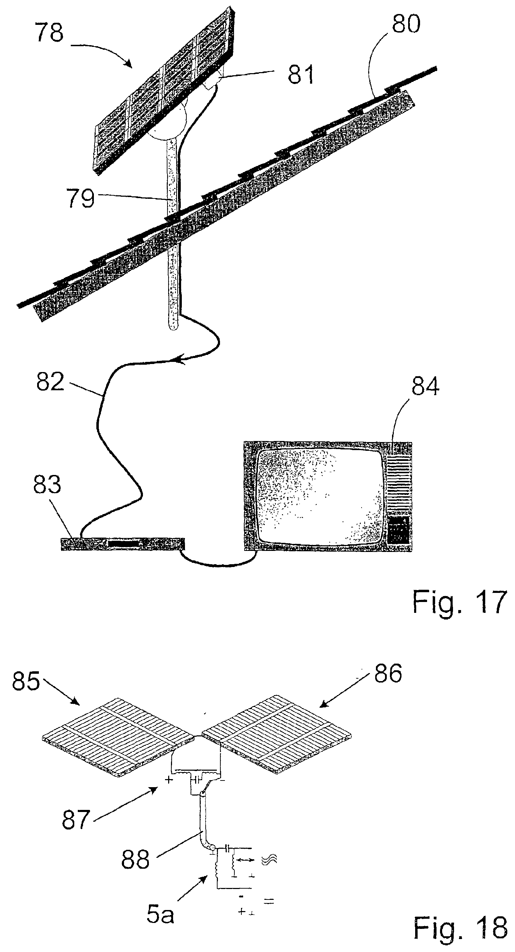

Fig. 17 und 18 zwei weitere Anwendungsbeispiele für die Vorrichtung nach Fig. 1; und

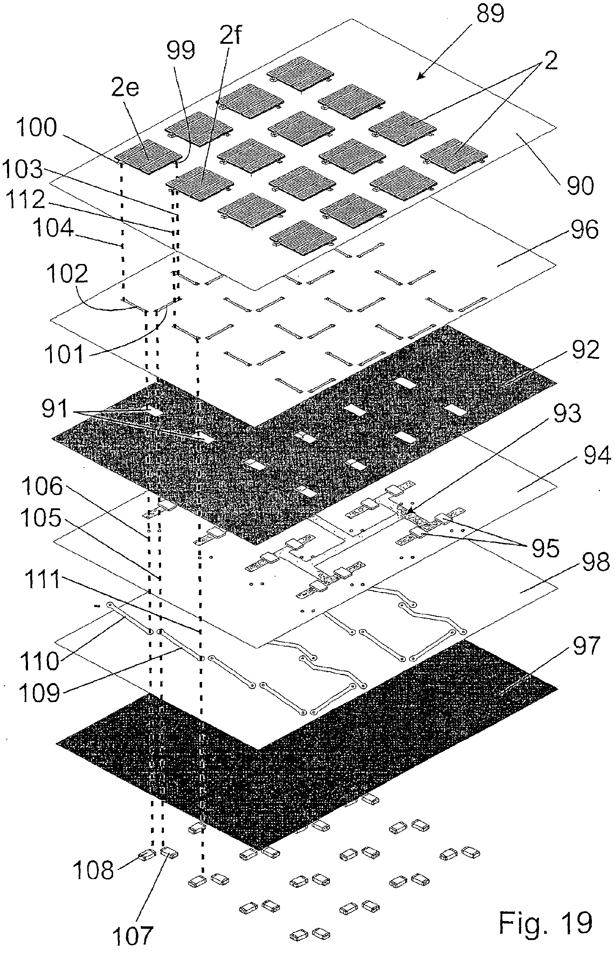

Fig. 19 eine der Fig. 10 entsprechende Darstellung einer Planarantenne mit einer anderen Art der Entkopplung von Gleich- und Wechselstromkomponenten.

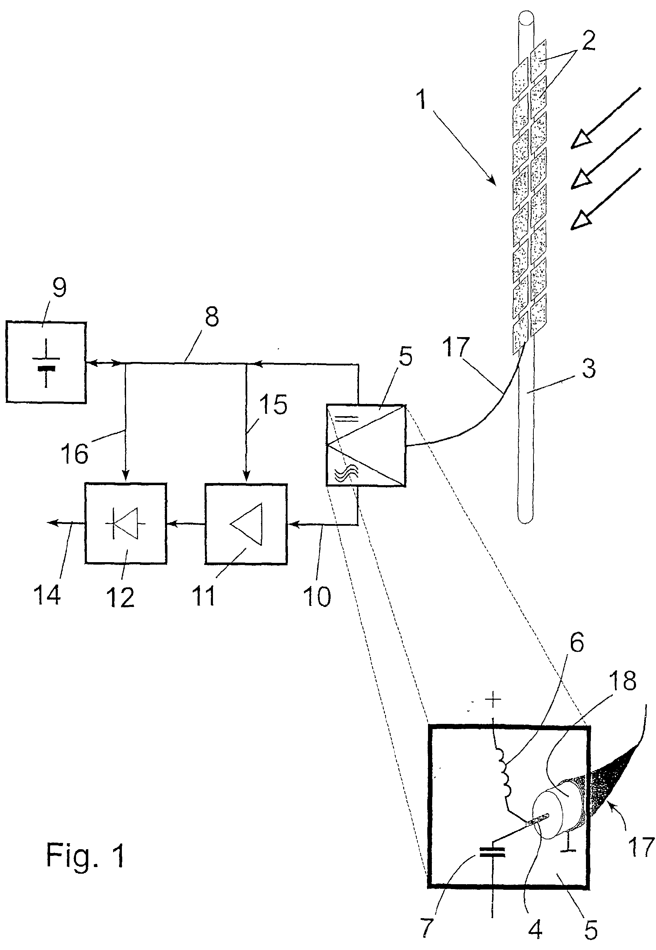

Fig. 1 zeigt eine Vorrichtung 1 mit einer Vielzahl von hier sechszehn Solarzellen 2, die z.B. ein Modul oder Array einer real betriebenen Fotovoltaikanlage bilden, an einem geeigneten Träger 3 montiert sind und der Umwandlung von auf sie treffender Solarenergie in elektrische Energie dienen. Die Solarzellen 2 sind nach irgendeiner heute üblichen Technik hergestellt und bestehen z.B. aus einer im wesentlichen planparallelen Platte, die in der Draufsicht rechteckig oder quadratisch ist und eine Dick von wenigen Milimetern besitzt. Außerdem besteht jede Solarzelle 2 vorzugsweise aus einem Halbleiterkörper, z.B. einem kristallinen Silicium-Grundkörper, der auf seiner Oberseite ein übliches Kontaktgitter und auf seiner Unterseite eine vollflächig durchgehende, leitfähige, meistens aus Metall bestehende Kontaktschicht aufweist. Die verschiedenen Solarzellen 2 sind außerdem bezüglich Gleichstrom in an sich bekannter Weise durch elektrische Leitung in Serien- und/oder Parallelschaltung miteinander verbunden und bei Bedarf mit üblichen Abdeckschichten aus Glas oder Kunststoff versehen.

Erfindungsgemäß wird die Vorrichtung 1 gleichzeitig als Antenne zum Abstrahlen und/oder Empfangen von hochfrequenten, elektromagnetischen Wellen benutzt. Hierzu wird wenigstens ein Kontakt wenigstens einer Solarzelle 2 gleichzeitig als Antennenelement, z.B. als Element einer Planarantenne benutzt. Dadurch ergibt sich der Vorteil, daß ein bei der Solarzelle 2 vorhandener elektrische Kontakt für eine zweite Funktion genutzt werden kann und dadurch zusätzliche Bauteile vermieden werden.

In Fig. 1 ist der Fall dargestellt, daß die Antenne als Empfangsantenne benutzt wird.

Dadurch wird das Solarzellenmodul einerseits beim Auftreffen von Solarenergie zu deren Umwandlung in elektrische Energie, andererseits beim Auftreffen von elektromagnetischen Wellen zu deren Empfang und Weiterleitung durch elektrische Leitungen verwendet.

Zur Lösung der beiden unterschiedlichen Aufgaben wird nach Fig. 1 z.B. der positive Kontakt des Solarzellenmoduls mittels einer elektrischen Leitung 4 an eine Weiche 5 angeschlossen, die dazu dient, die durch Umwandlung der Solarenergie erhaltene Gleichstromkomponente von der durch Bestrahlung mit HF-Wellen erhaltenen Wechselstromkomponente zu trennen. Dies erfolgt, wie in Fig. 1 unten rechts durch eine vergrößerte Darstellung der Weiche 5 angedeutet ist, durch eine Verzweigung, die eine zum Durchlaß der Gleichstromkomponente und Abtrennen der Wechselstromkomponente bestimmte Induktivität 6, z.B. in Form einer Spule und eine zum Durchlaß der Wechselstromkomponente und Abtrennen der Gleichstromkomponente bestimmte Kapazität 7 z.B. in Form eines Kondensators aufweist. Die Induktivität 6 ist ferner über eine elektrische Leitung 8 z.B. mit einer Batterie 9 verbunden, um diese bei Sonneneinstrahlung zu laden bzw. im geladenen Zustand zu halten, während die Kapazität 7 über eine elektrische Leitung 10 zu einem Empfänger 11 und von dort zu einem Demodulator 12 führt, dessen Ausgang 14 Daten bzw. Signale für die weitere Bearbeitung entnommen werden. Außerdem kann die Leitung 8 über weitere Leitungen 15,16 mit den der Stromversorgung dienenden Anschlüssen des Empfängers 11 bzw. des Demodulators 12 verbunden sein, so daß diese wahlweise direkt aus Solarenergie oder mit Hilfe der Batterie 9 gespeist werden können. Wie Fig. 1 ferner zeigt, ist die Leitung 4 zweckmäßig der Innenleiter eines Koaxialkabels 17, dessen äußeres Geflecht 18 zusammen mit dem negativen Kontakt des Solarzellenmoduls an Masse gelegt ist.

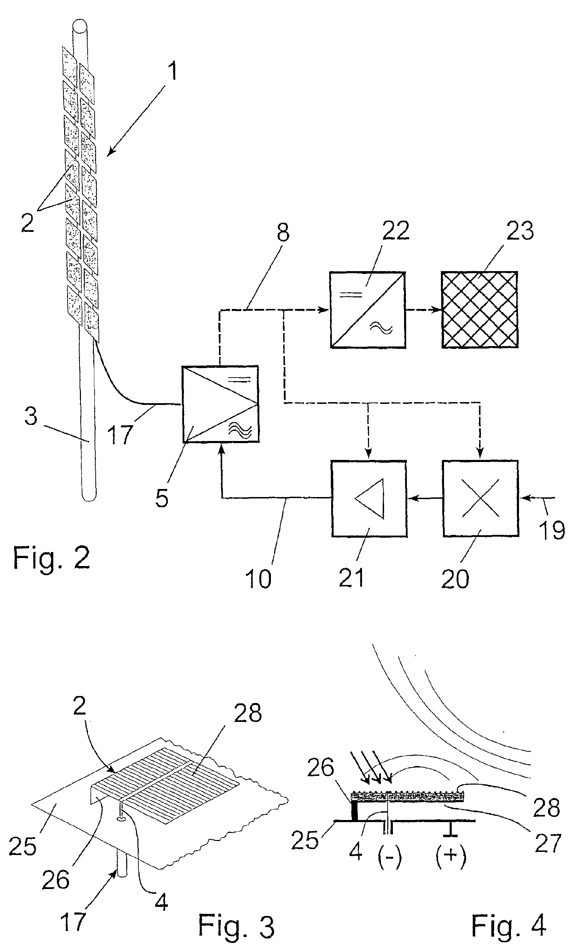

Ist es erwünscht wenigstens einen Kontakt wenigstens einer Solarzelle 2 als Sendeantenne zu benutzen, wird z.B. entsprechend Fig. 2 vorgegangen. Im Unterschied zur Fig. 1 werden Signale über eine Leitung 19 einem Modulator 20 und von dort einem Sender 21 zugeführt, von wo aus sie über die Leitung 10, die Weiche 5 und die Leitung 4 dem wenigstens einen Kontakt der wenigstens einen Solarzelle 2 zugeführt und von dieser in Form von elektromagnetischen Wellen in den Raum abgestrahlt werden. Außerdem zeigt Fig. 2 schematisch, daß der über die Leitung 8 entnommene Gleichstrom wahlweise auch einem Wechselrichter 22 zugeführt, von diesem in einen Wechselstrom gewandelt und dann in ein elektrisches Stromversorgungsnetz 23 eingespeist werden kann. Dabei können die Vorrichtungen nach Fig. 1 und 2 auch miteinander kombiniert werden, indem z.B. die Teile 11,12 einerseits und 20,21 andererseits über einen Schalter mit der Leitung 10 verbunden werden, um je nach Schalterstellung senden oder empfangen zu können.

Im übrigen ist klar, daß die aus der Solarenergie erhaltenen Gleichströme bzw. Gleichspannungen wegen der Weiche 5 völlig von hochfrequenten, elektromagnetischen Wellen entkoppelt sind und daß daher die Gleich- und Wechselstromkomponenten jeweils für sich an sich bekannter Weise behandelt bzw. verarbeitet werden können. Dabei ist es möglich, den als Antennenelement wirkenden Kontakt durch Wahl der Größe der abstrahlenden bzw. empfangenden Solarzelle(n) 2 auf die im Einzelfall gewünschte HF-Frequenz bzw. das zu verarbeitende HF-Frequenzband abzustimmen, zwei oder mehr Solarzellen 2 zur Herstellung einer die Dipol- oder Gruppenantenne zu verwenden oder der Antenne durch Schaltungsmaßnahmen eine vorgewählte Richtwirkung zu geben.

Fig. 3 bis 9 zeigen jeweils eine einzige, in üblicher Weise ausgebildete und verwendete Solarzelle 2 und verschiedene Kopplungsarten für die HF-Energie.

In Fig. 3 und 4 ist die schon aus Fig. 1 ersichtliche Kopplung über das Koaxialkabel 17 gezeigt. Als Träger der Solarzelle 2 dient eine an Masse gelegte Metallplatte 25, die über einen ebenfalls aus Metall bestehenden Steg 26 mit einer auf der Unterseite der Solarzelle 2 befindlichen, z.B. den positiven Anschluß bildenden Kontaktschicht 27 (Fig. 4) verbunden ist. Dagegen ist ein auf der Oberseite der Solarzelle 2 befindliches, z.B. den negativen Anschluß bildendes Kontaktgitter 28 durch Öffnungen in der Kontaktschicht 27 und der Metallplatte 25 hindurch mit dem Innenleiter 4 des Koaxialkabels 17 verbunden, wobei der Innenleiter 4 entsprechend Fig. 1 und 2 angeschlossen und das äußere Geflecht des Koaxialkabels 17 mit der Metallplatte 25 verbunden wird. Die dadurch geschaffene Antenne könnte als PIFA (planar inverted F-Antenna) bezeichnet werden. Außerdem kann zwischen der Metallplatte 25 und der Kontaktschicht 27 ein Substrat aus einem elektrisch nicht leitenden Material angeordnet sein.

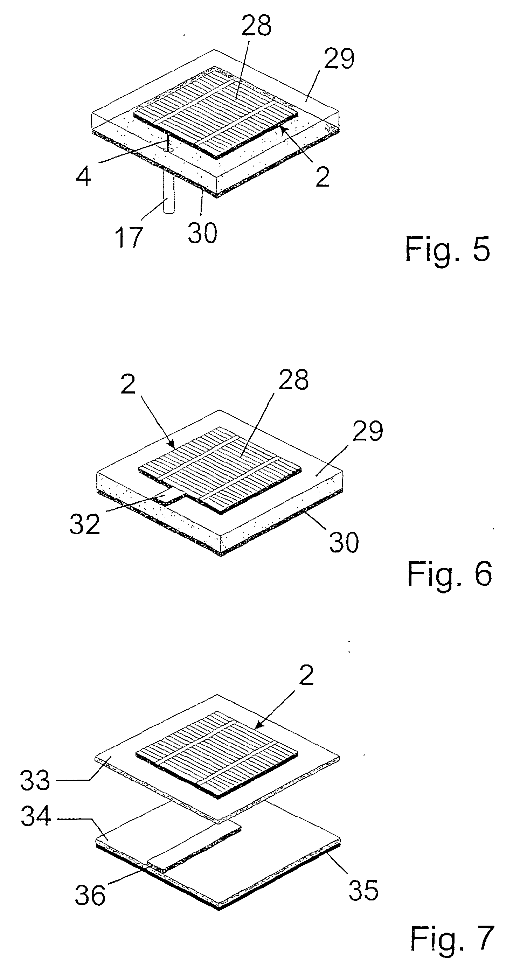

Fig. 5, in der die derzeit für am besten gehaltene Ausführungsform der Erfindung dargestellt ist, zeigt eine Kopplung mittels des Koaxialkabels 17 bei Anwendung der Solarzelle 2 als Planarantenne. Die Solarzelle 2 ist hier z.B. durch Kleben auf der Oberseite eines Substrats 29 aus einem elektrisch isolierenden Material befestigt, an dessen Unterseite eine an Masse gelegte Metallplatte 30 befestigt ist. Das obere, z.B. negative Kontaktgitter 28 liegt im Gegensatz zu Fig. 3 und 4 an Masse, während der Innenleiter 4 des Koaxialkabels 17 durch Öffnungen im Substrat 29 und in der Metallplatte 30 hindurch mit der unteren, z.B. positiven Kontaktschicht 27 (Fig. 4) der Solarzelle 2 verbunden ist. Im Gegensatz zu Fig. 3 und 4 fehlt außerdem lediglich der verbindende Kurzschluß-Steg 26, woraus im Hinblick auf die Antennenwirkung andere Ressonanzfrequenzen resultieren.

Fig. 6 zeigt das Beispiel einer direkten Kopplung in Verbindung mit einer Planarantenne. Die HF-Einspeisung bzw. HF-Entnahme erfolgt hier durch einen auf dem Substrat 29 ausgebildeten Streifen 32 aus einem elektrisch leitenden Material, der analog zu Fig. 3 bis 5 mit der unteren, z.B. positiven Kontaktschicht 27 (Fig. 4) der Solarzelle 2 verbunden ist und an die Weiche 5 nach Fig. 1 und 2 angeschlossen wird. Im übrigen ist die Anordnung analog zu Fig. 5.

Bei der in auseinander gezogener Darstellung gezeigten Anordnung nach Fig. 7 handelt es sich um eine Strahlungskopplung. Die Solarzelle 2 ist hier mit ihrer unteren Kontaktschicht 27 (Fig. 4) auf der Oberseite eines ersten Substrats 33 aus einem elektrisch isolierenden Material z.B. durch Kleben befestigt, dessen Unterseite mit der Oberseite eines zweiten elektrisch isolierenden Substrats 34 verbunden ist, an dessen Unterseite eine als Masse dienende Metallplatte 35 z.B. durch Kleben befestigt ist. Zwischen den beiden Substraten 33 und 34 ist ein Streifen 36 aus einem elektrisch leitenden Material befestigt, durch den die HF-An-bzw. Auskopplung erfolgt und der analog zu den übrigen Darstellungen mit der Weiche 5 verbunden, aber auch direkt mit einem Sender oder Empfänger verbunden werden könnte. Die Breite des Streifens 36 ist wesentlich kleiner als die Breite der darüber befindlichen, ihm zugeordneten und als Antennenelement dienenden Kontaktschicht 27 (Fig. 4) der Solarzelle 2.

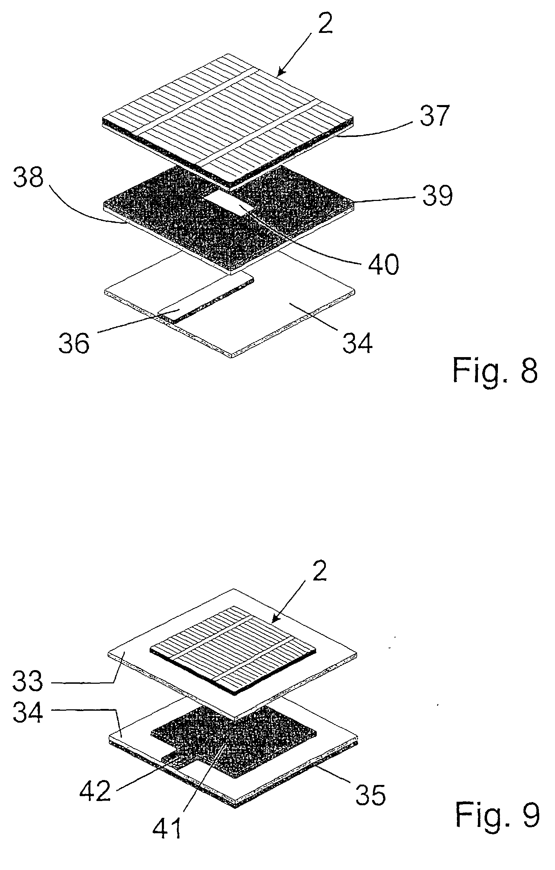

In Fig. 8 ist in auseinander gezogener Darstellung eine Schlitzkopplung angedeutet. Die Solarzelle 2 ist mit ihrer Kontaktschicht 27 (Fig. 4) auf der Oberseite eines elektrisch nicht leitenden Substrats 37 befestigt. Ein analog zu Fig. 7 ausgebildetes Substrat 35 mit einem elektrisch leitenden Streifen 36 ist unterhalb des Substrats 37 angeordnet. Zwischen beiden Substraten 35,37 ist ein drittes Substrat 38 aus einem elektrisch isolierenden Material angeordnet, auf dessen dem Substrat 37 zugewandten Oberseite eine Metallplatte 39 befestigt ist, die in der Mitte ein Schlitz 40 aufweist. Die drei, vorzugsweise plattenförmigen Substrate 35,37 und 38 werden in der aus Fig. 8 ersichtlichen Weise übereinandergelegt und fest miteinander verbunden, wobei der Streifen 36 zwischen den Substraten 35 und 38 und die Metallplatte 37 zwischen den Substraten 38 und 37 zu liegen kommt. Der Steifen 36 ist einerseits so auf den Substrat 35 angeordnet, daß der im fertig montierten Zustand unterhalb des Schlitzes 40 liegt, und wird andererseits mit der Weiche 5 nach Fig. 1 und 2 oder direkt mit einem Sender oder Empfänger verbunden.

Fig. 9 zeigt schließlich, ebenfalls in auseinandergezogener Darstellung, eine kapazitive Kopplung. Die Anordnung ist ähnlich zu Fig. 7 mit dem einzigen Unterschied, daß der schmale Streifen 36 (Fig. 7) durch eine Metallplatte 41 ersetzt ist, deren Größe im wesentlichen der Größe der Kontaktschicht 27 (Fig. 4) der Solarzelle 2 entspricht und die zusammen mit dieser Kontaktschicht 27 einen Kondensator bildet. Die Anregung bzw. Entnahme der Hochfrequenz erfolgt mit einem Anschluß 42 der Metallplatte 41, der zur Weiche 5 oder direkt zu einem Sender oder Empfänger geführt wird. Die Kontaktschicht 27 der Solarzelle 2 ist hier kapazitiv mit der Metallplatte 41 gekoppelt.

Bei der Anordnung nach Fig. 9 bildet die Solarzelle 2 wie bei den Anordnungen nach Fig. 5 bis 8 eine Planarantenne, wobei z.B. das obere Kontaktgitter einen negativen und die untere Kontaktschicht einen positiven Anschluß bildet. Die Weiche 5 wird wie bei den Vorrichtungen nach Fig. 7 und 8 nicht benötigt, da keine direkte Verbindung mit der als Antennenelement wirksamen Kontaktschicht der Solarzelle 2 besteht. Es ist allerdings zweckmäßig, die Solarzelle 2 durch eine Induktivität od. vom Wechselstrom zu entkoppeln, um zu vermeiden, daß dieser zu einem Verbraucher gelangt.

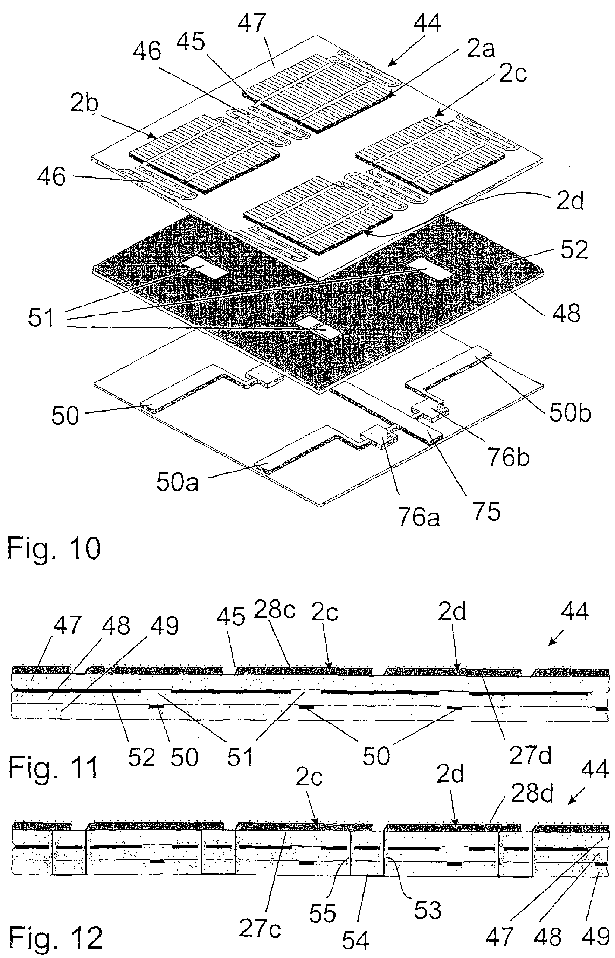

Fig. 10 zeigt einen Ausschnitt aus einer Vorrichtung 44 in Form eines Solarzellenmoduls, wobei dieser Ausschnitt 4 z.B. nach Fig. 1 bis 9 ausgebildete Solarzellen 2a bis 2d enthält und die Solarzellen 2a, 2b bzw. 2c, 2d bezüglich Gleichstrom paarweise in Reihenschaltung miteinander verbunden sind. Die beiden Reihenschaltungen können außerdem, was nicht näher dargestellt ist, wahlweise in Parallel- und/oder ebenfalls in Reihenschaltung verbunden sein. Bezüglich hochfrequentem Wechselstrom sind die einzelnen Solarzellen 2a bis 2d voneinander entkoppelt. Dies wird beispielsweise entsprechend Fig. 11 dadurch erreicht, daß jeweils das Kontaktgitter 28c einer ersten Solarzelle 2c durch eine Leitung 45 mit der Kontaktschicht 27d einer in Reihenschaltung folgenden Solarzelle 2d verbunden und in diese Leitung 45, wie in Fig. 10 angedeutet ist, eine Induktivität 46 geschaltet wird, indem die Leitung 45 z.B. nach Art einer Schleife bzw. Windung verlegt wird. Die Größe der Induktivitäten 46 wird so gewählt, daß sie den Durchgang von hochfrequentem Wechselstrom blockieren. Die Ausbildung der Induktivitäten 46 könnte auch auf andere Weise erfolgen.

Im übrigen werden die Solarzellen 2a bis 2d bezüglich hochfrequenten Wechselfeldern analog zu Fig. 8 z.B. durch Schlitzkopplung gekoppelt. Hierzu werden alle Solarzellen 2a bis 2d mit ihren Kontaktschichten (z.B. 27d) auf einem gemeinsamen, plattenförmigen Substrat 47 befestigt, das mit zwei weiteren, plattenförmigen Substraten 48 und 49 zu einer festen Baueinheit verbunden ist. Zwischen den einzelnen Solarzellen 2a bis 2d bleiben jeweils Spalte frei. Analog zu Fig. 8 ist zwischen den Substraten 49 und 48 eine dem Streifen 36 entsprechende, zur Ein- und Auskopplung von hochfrequentem Wechselstrom bestimmte Streifenanordnung 50 und zwischen den Substraten 48 und 47 eine mit Schlitzen 51 versehene Metallplatte 52 angeordnet, wobei jeder unteren Kontaktschicht (z.B. 27d in Fig. 11) der Solarzellen 2a bis 2d je ein Schlitz 51 zugeordnet ist, der z.B. etwa in der Mitte der betreffenden Kontaktschicht zu liegen kommt, so daß zwischen den Solarzellen 2a bis 2d frei bleibenden Spalte, wie Fig. 11 zeigt, jeweils von der Metallplatte 52 überbrückt werden. Durch Wahl der Lage und Größe der Schlitze 51 kann die Antennenfunktion wie im Fall der Fig. 8 optimiert werden.

Die Leitungen 45 werden zweckmäßig dadurch hergestellt, daß sie mit Hilfe von in der Halbleitertechnik üblichen Verfahren auf der oberen Oberfläche des Substrats 47 ausgebildet, mit den Kontaktschichten (z.B. 27d) verbunden und dann durch senkrecht dazu verlaufenden Kontakte an die zugehörigen Kontaktgitter (z.B. 28c) angeschlossen werden. Dadurch kann die gesamte aus Fig. 10 und 11 ersichtliche Vorrichtung 44 unter Anwendung der bei der Platinenfabrikation üblichen Multilayer- bzw. Schichttechnik in kostengünstiger Weise hergestellt werden.

Die Alternative nach Fig. 12, in der gleiche Teile mit denselben Bezugszeichen versehen sind, unterscheidet sich von der nach Fig. 11 nur dadurch, daß die Kontaktgitter (z.B. 2c) mit Hilfe von die Substrate 47, 48 und 49 sowie Öffnungen in der Metallplatte 52 durchsetzenden Kontakten 53 mit den Anfängen von auf der Rückseite des Substrats 49 angebrachten Leitungen 54 verbunden sind, die analog zu den Leitungen 45 schleifenförmig verlegt sein können und deren Enden mit Hilfe von weiteren durchgehenden Kontakten 55 mit den Kontaktschichten (z.B. 27d in Fig. 12) der jeweils nächsten Solarzelle (z.B. 2d) verbunden sind. Eine solche Anordnung ist besonders dann zweckmäßig, wenn die Spalten zwischen den Solarzellen 2a bis 2d zu klein für eine Schleifenbildung in den Leitungen 45 (Fig. 10,11) sind.

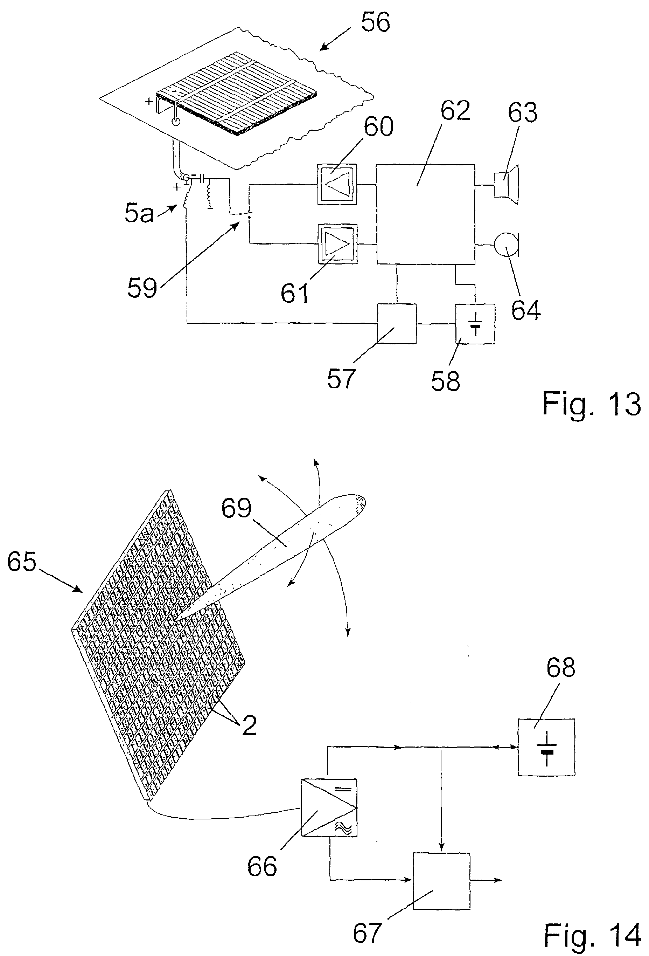

Fig. 13 zeigt ein Anwendungsbeispiel für eine erfindungsgemäße, aus wenigstens einer Solarzelle 2 mit integrierter Antenne bestehende Vorrichtung 56, die analog zu Fig. 3 und 4 ausgebildet und in einem tragbaren Funktelefon untergebracht ist. Mittels einer der Weiche 5 nach Fig. 1 und 2 entsprechenden Weiche 5a wird der Gleichstromanschluß mit einem Ladegerät 57 für eine Batterie 58 und der Wechselstromanschluß mit einem Umschalter 59 verbunden. Dieser ist einerseits mit einem Sendeteil 60, andererseits mit einem Empfangsteil 61 verbunden. Außerdem ist ein Steuerblock 62 vorhanden, der der Signalverarbeitung und dem Leistungsmanagement dient und daher über entsprechende Anschlüsse z.B. mit je einem Lautsprecher 63 und Mikrophon 64 bzw. dem Ladegerät 57 und der Batterie 58 verbunden ist. Durch Betätigung des Umschalters 59 kann wahlweise auf Hören und Sprechen bzw. Empfangen und Senden umgeschalten werden.

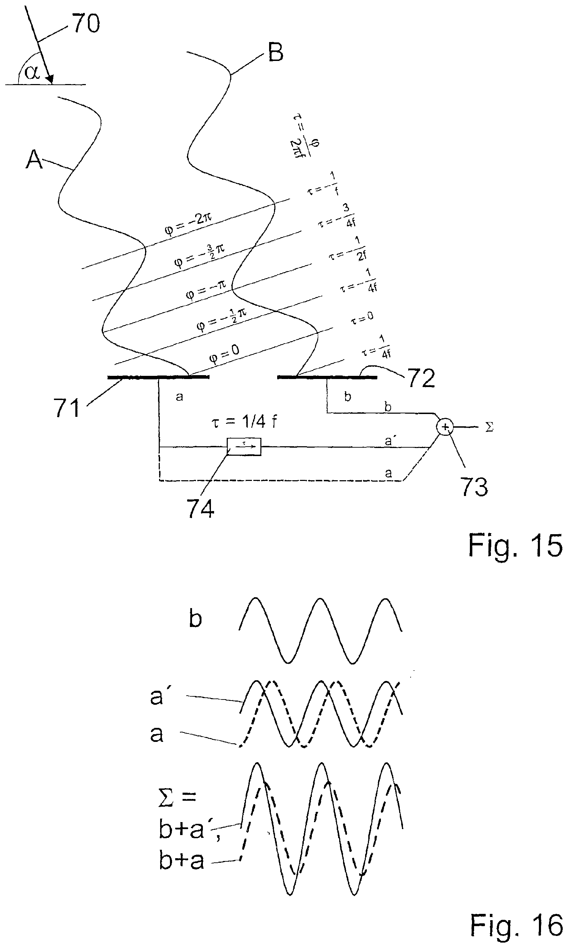

Fig. 14 betrifft ein Ausführungsbeispiel, das eine erfindungsgemäße Vorrichtung 65 mit einer Vielzahl von in Parallel- und/oder Reihenschaltung verbundenen Solarzellen 2 aufweist, deren Kontakte gleichzeitig als Antennenelemente genutzt werden. Die Vorrichtung 65 bildet daher gleichzeitig eine Gruppenantenne. Die Antennenkopplung erfolgt z.B. analog zu Fig. 1 mit einem Koaxialkabel und einer der Weiche 5 entsprechenden Weiche 66. Die von den Solarzellen 2 gebildete Planarantenne dient hier zum Satellitenempfang, wozu die HF-Signale einem Satellitenempfänger 67 zugeführt werden. Der zur Erzeugung von elektrischer Energie dienende Gleichstrom wird einer Batterie 68 oder zum Direktverbrauch dem Satellitenempfänger 66 zugeführt. Mit dem Bezugszeichen 69 ist außerdem eine übliche Antennenkeule angedeutet. Deren Hauptachse, die in Fig. 15 durch einen Pfeil 70 angedeutet ist, ist z.B. durch die Lage eines zugeordneten Satellitensenders gegeben und bildet beispielsweise einen von 90° abweichenden Winkel α mit der im wesentlichen ebenen Oberfläche der Solarzellen 2.

In Fig. 15 sind ferner zwei Antennenelemente 71,72 der Gruppenantenne nach Fig. 14 angedeutet, die z.B. durch die unteren Kontaktschichten 27 (Fig. 4) von zwei benachbarten Solarzellen gebildet sind und HF-Signale a bzw. b empfangen. Wegen des schrägen Einfalls der durch Wellen A und B angedeuteten HF-Strahlung erreicht die Welle A das Antennenelement 71 zeitlich früher, d.h. bevor die Welle B das Antennenelement 72 erreicht. Im Ausführungsbeispiel beträgt der Phasenunterschied ϕ = -1/2π, woraus eine zeitliche Verzögerungszeit τ=1/4f resultiert. Dies ist in Fig. 16 durch die HF-Signale a (gestrichelt) und b (durchgezogen) angedeutet. Würden daher die Signale a und b in üblicher Weise in einer Additionsstufe 73 addiert, würde in Fig. 16 das gestrichelt angedeutete Signal Σ=b+a erscheinen, das aufgrund der Phasenverschiebung nicht optimal ist. Wird dagegen das Signal a in einer Verzögerungsstufe 74 unter Bildung eines Signals a' um den Wert τ=1/4f gegenüber dem Signal b verzögert, dann haben beide an den Eingängen der Additionsstufe 73 diesselbe Phase, so daß das Summensignal Σ=b+a' eine optimal Amplitude besitzt. Fällt die Strahlung unter einem vom Winkel α nach Fig. 15 abweichenden Winkel ein, muß die Verzögerungsstufe 74 zur optimalen Anpassung des Summensignals ∑ entsprechend auf eine andere Verzögerungszeit eingestellt werden. Dies gilt entsprechend für alle durch die Solarzellen 2 der Vorrichtung 65 nach Fig. 14 gebildeten Antennenelemente.

Umgekehrt kann für den Fall, daß die Vorrichtung 65 gleichzeitig als Sendeantenne dienen soll, durch entsprechende zeitliche Verzögerungen der den einzelnen Antennenelementen zugeführten HF-Signale erreicht werden, daß die Hauptachse der Antennenkeule 69 eine gewünschte Richtung einnimmmt. Hierzu können z.B., wie in Fig. 10 angedeutet ist, zwischen eine gemeinsame HF-Zuleitung 75 der Streifenanordnung 50 und den Schlitzen 51 zugeordnete Streifenabschnitte 50a,b usw. je eine Verzögerungsstufe 76a, 76b geschaltet werden. Durch Änderung der Verzögerungszeiten kann die Richtung der Antennenkeule 69 dann je nach Bedarf geändert werden, wie in Fig. 14 durch Pfeile angedeutet ist, wodurch eine strahlschwenkende Gruppenantenne erhalten wird. Die hierzu erforderlichen Mittel sind in der Antennentechnik allgemein bekannt und brauchen daher nicht näher erläutert werden.

Die Erfindung ist nicht auf die beschriebenen Ausführungsbeispiele beschränkt, die in vielfacher Weise abgewandelt werden können. Dies gilt insbesondere für die beschriebenen Kopplungsarten, die durch andere Kopplungsarten ersetzt werden können. Weiter sind diejenigen Kontakte der Solarzellen, die erfindungsgemäß als Antennenelemente verwendet werden sollen, nur als Beispiel aufzufassen. Weiter wäre es möglich, die erfindungsgemäßen Vorrichtungen an andere Antennenformen, insbesondere z.B. für Satellitenempfang geeignete Parabolantennen anzupassen. Zu diesen Zweck könnten die Solarzellen 2 z.B. längs Parabelflächen angeordnet werden. Weiter wäre es möglich, bei der z.B. aus Fig. 10 ersichtlichen Ausführungsform alle Solarzellen in Parallelschaltung statt in Serienschaltung zu verbinden und dazu deren Kontaktgitter über Induktivitäten mit einer ersten Leitung und die Kontaktschichten über weitere Induktivitäten mit einer zweiten Leitung zu verbinden. Wegen der Entkopplung von den Gleichstromkomponenten ist es im Hinblick auf die Antennenfunktion gleichgültig, ob die Solarzellen bezüglich Gleichstrom parallel und/oder in Serie geschaltet sind. Außerdem ist es vür die Antennenfunktion weitgehend unbedeutend, ob bezüglich des Gleichstroms die Kontaktgitter 28 den negativen und die Metallschichten 27 den positiven Anschluß bilden oder umgekehrt, so daß diese Polarität dieser Anschlüsse nach den Bedürfnissen der Solartechnik gewählt werden können. Schließlich versteht sich, daß die verschiedenen Merkmalen auch in anderen als die dargestellten und beschriebenen Kombinationen angewendet werden können.

## Patentansprüche

1. Vorrichtung zur Umwandlung von Solarenergie in elektrische Energie und zum Abstrahlen und/oder Empfangen von hochfrequenten, elektromagnetischen Wellen, enthalten wenigstens eine mit elektrisch leitenden und die Elektroden bildenden Kontakten (27,28) versehene Solarzelle (2) und eine mit wenigstens einem Antennenelement versehene Antenne, dadurch gekennzeichnet, daß das Antennenelement durch wenigstens einen der Kontakte (27,28) der Solarzelle (2) gebildet ist.

2. Vorrichtung nach Anspruch 1, dadurch gekennzeichnet, daß der wenigstens eine Kontakt (27) mit einer Weiche (5,56,66) zur Trennung einer von der Solarzelle (2) erzeugten Gleichstromkomponente von einer durch die hochfrequenten Wellen gebildeten Wechselstromkomponente verbunden ist.

3. Vorrichtung nach Anspruch 2, dadurch gekennzeichnet, daß die Weiche (5,65,66) eine Induktivität (6) für die Gleichstromkomponente und eine Kapazität (7) für die Wechselstromkomponente aufweist.

4. Vorrichtung nach Anspruch 1, dadurch gekennzeichnet, daß der wenigstens eine Kontakt (27) durch eine Strahlungs- , Schlitz- oder kapazitive Kopplung zur Ein- bzw. Auskopplung von durch die hochfrequenten Wellen gebildeten Wechselstromkomponente eingerichtet ist.

5. Vorrichtung nach einem der Ansprüche 1 bis 4, dadurch gekennzeichnet, daß sie eine Mehrzahl von Solarzellen (2,2a bis 2b) enthält, die elektrisch leitende Kontakte (27d,28c) aufweisen, die bezüglich Gleichstrom durch elektrische Leitungen (45) in Serien- und/oder Parellelschaltung verbunden sind.

6. Vorrichtung nach Anspruch 5, dadurch gekennzeichnet, daß die Gleichstromkomponenten der einzelnen Solarzellen (2,2a bis 2d) durch in den Leitungen (45) vorgesehene Induktivitäten (46) von den hochfrequenten Wechselstromkomponenten entkoppelt sind.

7. Vorrichtung nach einem der Ansprüche 1 bis 6, dadurch gekennzeichnet, daß die Solarzellen (2,2a bis 2d) aus plattenförmigen Bauteilen bestehen, deren Kontakte aus je einem auf ihrer Vorderseite angebrachten Kontaktgitter (28) und einer auf ihrer Rückseite angebrachten Kontaktschicht (27) bestehen.

8. Vorrichtung nach Anspruch 7, dadurch gekennzeichnet, daß die Solarzellen (2a bis 2d) zu einem Solarzellenmodul (44) zusammengefaßt und durch Spalte voneinander getrennt sind.

9. Vorrichtung nach Anspruch 8, dadurch gekennzeichnet, daß die Solarzellen (2a bis 2d) mit ihren Kontaktschichten (27) auf einer Oberseite eines plattenförmigen Substrats (47) aus elektrischem Isoliermaterial aufliegen, das auf einer Unterseite mit einer die Spalte überbrückende, Schlitze (51) aufweisenden Metallplatte (52) und einer den Schlitzen zugeordneten Streifenanordnung (50) aus elektrisch leitenden Materila zum Ein- bzw. Auskoppeln der HF-Wellen versehen ist.

10. Vorrichtung nach Anspruch 9, dadurch gekennzeichnet, daß die Metallplatte (52) und die Streifenanordnung (50) durch ein Substrat (48) aus elektrischem Isoliermaterial getrennt sind.

11. Vorrichtung nach einem der Ansprüche 1 bis 10, dadurch gekennzeichnet, daß sie in Schichtbauweise hergestellt ist und die Kontakte (27,28) und Leitungen (45) in Dick- oder Dünnschichttechnik aufgebracht sind.

12. Vorrichtung nach einem der Ansprüche 5 bis 8, dadurch gekennzeichnet, daß die Induktivitäten (46) durch schleifenförmige Verlegung der Leitungen (45) gebildet sind.
